# EUROPEAN PATENT APPLICATION

(11) **EP 4 582 822 A1**
(43) Date of publication of application: **09.07.2025**
(21) Application number: 24219790.3
(22) Date of filing: 13.12.2024
(51) Int. Cl.: G01R 31/389

(54) **STIMULUS SOURCING FOR HYDROGEN STACK EIS-BASED HEALTH ASSESSMENT**

(30) Priority: 20.12.2023 US 202363612896 P; 09.10.2024 US 202418910802
(71) Applicant: Analog Devices International Unlimited Company, Limerick (IE)
(72) Inventor: RYAN, David Thomas, Co. Limerick (IE); ELKIN, Igor, Wilmington, 01887 (US); O'MAHONY, Shane, Co. Limerick (IE); HARRINGTON, Brian, Wilmington, 01887 (US)
(74) Representative: Wallin, Nicholas James

(57) **Abstract**

A measurement device for an electrochemical system includes a stimulus circuit configured to simultaneously apply a direct current (DC) stimulus and an alternating current (AC) stimulus to one or more electrochemical cells of the electrochemical system, wherein the AC stimulus is applied at multiple frequencies; an impedance measurement circuit configured to measure impedance of the one or more electrochemical cells; and a controller configured to synchronize application of the DC stimulus and AC stimulus with measuring of impedance at the multiple frequencies and record the measured impedance of the one or more electrochemical cells.

## Description

### PRIORITY APPLICATIONS

This Application claims the benefit of priority to U.S. Provisional Patent Application Serial Number 63/612,896 filed 20 December 2023, which is incorporated herein by reference in their entirety.

### FIELD OF THE DISCLOSURE

This document relates to measurement apparatuses and methods and, in particular, to electrochemical system measurement apparatuses and methods.

### BACKGROUND

An electrolyser system can include multiple hydrogen producing cells connected together as a cell stack. Hydrogen producing cells may be prone to failures. Electrical impedance spectroscopy (EIS) is a measurement of electrochemical impedance. Electrochemical impedance is usually measured by applying an AC (alternating current) signal, such as a sinusoidal test voltage or current, to an electrochemical cell under test and then measuring the current or voltage through the electrochemical cell over a suitable frequency range. This technique can be used to investigate the electrochemical properties of devices such as hydrogen producing cells to assess the health of the hydrogen producing cells.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 is a block diagram of portions of an example of an electrochemical system.
FIG. 2 is a block diagram of portions of an example of an electrochemical system with Electrical Impedance Spectroscopy (EIS) monitoring capability.
FIG. 3 is a flow diagram of an example of a method of testing an electrochemical system.
FIG. 4 is a block diagram of another example of portions of an electrochemical system.
FIG. 5 is a block diagram of another example of portions of an electrochemical system.
FIG. 6 is a block diagram of another example of portions of an electrochemical system.

### DETAILED DESCRIPTION

Electrical impedance spectroscopy (EIS) can used to quantify the health status of electrochemical cells of electrochemical systems such as hydrogen electrolyser systems, fuel cell systems, or battery cell systems. An example EIS procedure includes applying an electrical stimulus to an electrochemical cell, waiting for a settling time, then measuring electrochemical impedance of the electrochemical cell. The frequency of the electrical stimulus signal is swept over a frequency range and the measured electrochemical impedance as a function of frequency is analyzed. EIS monitoring electronics attached to the electrochemical cell or cells can provide autonomous recording of signals associated with the electrochemical cell that can provide data regarding the status of the electrochemical cell.

Hydrogen electrolysers are a type of electrochemical system that has gained attention in the context of clean energy transitions and decarbonization efforts across different market sectors. Hydrogen electrolysers are devices used to produce hydrogen gas through a process called electrolysis in which water molecules are split into hydrogen (H₂) and oxygen (O₂) using electricity. EIS can be used to assess the health of an electrolyser cell or cell stack and predict the degradation of the electrolyser cells. EIS can also be used to assess the health of fuel cell systems and battery cell systems.

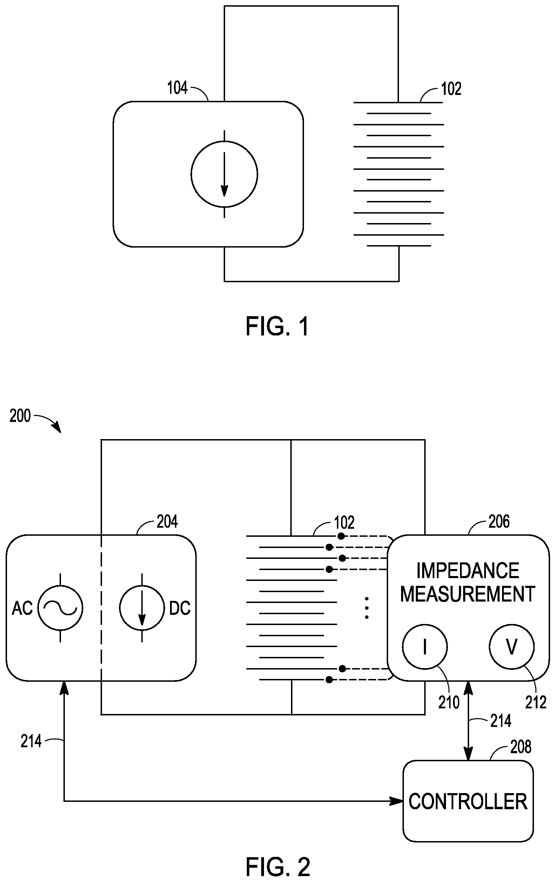

FIG. 1 is a block diagram of portions of an example of an electrochemical system that is a hydrogen electrolyser system 100. The system includes an electrochemical cell stack 102 and a power source 104. The electrochemical cell stack 102 includes multiple hydrogen production cells connected in series as a cell stack. The power source 104 applies a DC (direct current) bias to the cell stack 102 to produce hydrogen. Because hydrogen production cells can be prone to failures, it would be desirable to predict degradation of the hydrogen production cells. Monitoring the cell stack 102 using EIS would predict degradation of the cells.

FIG. 2 is a block diagram of an example of portions of a hydrogen electrolyser system 200 with EIS monitoring capability. The system includes a cell stack 102, a DC power source with stimulus circuit 204, and an impedance measurement circuit 206. The cell stack 102 may include multiple hydrogen producing cells as in the example of FIG. 1. The stimulus circuit 204 applies both a DC stimulus and an AC stimulus to the electrochemical cell stack 102. The DC stimulus is applied to produce hydrogen, and the AC stimulus is applied to measure electrochemical impedance of each of the hydrogen production cells of the cell stack 102. The AC stimulus is applied at multiple frequencies and the impedance measurement circuit 206 measures impedance of each of the electrochemical cells.

The system also includes a controller 208. The controller 208 includes logic circuitry to perform the functions described. The logic circuitry may include a microprocessor, an application specific integrated circuit (ASIC), or other type of processor, interpreting or executing instructions included in software or firmware. The logic circuitry may also include a precision clock. The controller 208 synchronizes application of the DC stimulus and AC stimulus with measuring of the impedance at the multiple frequencies.

The impedance measurement circuit 206 may include a precision current sensor 210 to measure the AC stimulus current. The current sensor 210 may include a shunt resistor, Hall effect sensor, current transformer, magnetic field sensor, or other type of precision current sensor. In an example intended to be non-limiting, the measurement of the current sensor 210 may produce a digital value of current having accuracy to twelve bits or more. The impedance measurement circuit 206 also includes a voltage sensor 212 to measure the AC voltage produced by the AC stimulus current.

The impedance measurement circuit 206 uses the values of current and voltage from the sensors to determine impedance of the electrochemical cells. The controller 208 records the measured impedance of the one or more electrochemical cells using memory that may be integral to the controller 208. The controller 208 may produce an indication of the condition of one or more of the hydrogen production cells using the determined electrochemical impedance at the multiple frequencies.

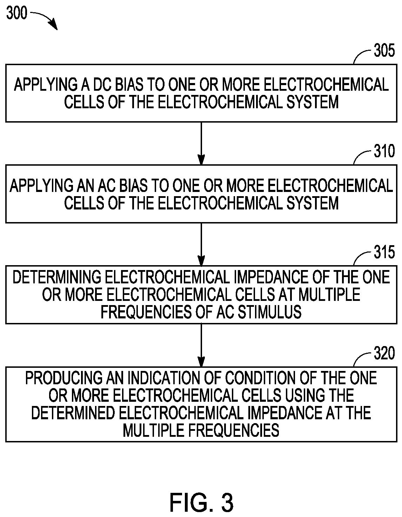

FIG. 3 is a flow diagram of an example of a method 300 of testing an electrochemical system that includes one or more electrochemical cells. At block 305, a DC bias is applied to the electrochemical cells. The electrochemical cells may be the hydrogen production cells of the hydrogen electrolyser system 200 of FIG. 2, and the DC bias may be DC energy applied to the cells to produce hydrogen. At block 310, the AC stimulus is applied with the DC bias to the one or more electrochemical cells. The AC stimulus is applied at multiple frequencies. In an example intended to be non-limiting, the AC stimulus is applied with frequencies included in the range of one hertz (1Hz) to ten kilohertz (10kHz). The electrochemical system includes an impedance measurement circuit (e.g., the impedance measurement circuit 206 in FIG. 2). At block 315, the electrochemical impedance of the cells is determined for the multiple frequencies.

The electrochemical system includes a controller (e.g., controller 208 in FIG. 2). The controller synchronizes the application of the DC stimulus and AC stimulus and synchronizes the application of the AC stimulus with the measuring of the impedance at the multiple frequencies. The AC stimulus may only be applied when the electrochemical impedance of the cells is to be measured. In some examples, the controller waits a specified settling time after the AC stimulus is applied before determining the electrochemical impedance.

The impedance measurement circuit provides a precision measurement of the AC stimulus current to the controller. In some examples, the controller samples the AC stimulus current at a sample rate of 5 kilo-samples per second (5ksps) or more. The impedance measurement circuit provides a measure of AC stimulus voltage of the electrochemical cells produced by the AC stimulus current. The controller determines the electrochemical impedance of the electrochemical cells using the measured values of AC current and voltage. The stimulus circuit applies the AC current to the electrochemical cells at multiple frequencies. The controller receives a measurement of voltage resulting from the AC current and determines the electrochemical impedance at the multiple frequencies.

At block 320, the controller may produce an indication of the condition of the one or more electrochemical cells based on the determined electrochemical impedance at the multiple frequencies. The controller processes the impedance data collected to detect any anomalies in the electrochemical cells of the cell stack. The controller may compare a curve of impedance data versus frequency measured for the electrochemical cells to a baseline curve of impedance data versus frequency. If the measured curve varies significantly from the baseline curve, the controller may produce an indication that one or more of the electrochemical cells has an anomaly or is defective.

Returning to FIG. 2, the controller 208 may or may not be co-located with the impedance measurement circuit 206 and the stimulus circuit 204. The controller 208 may send commands to the stimulus circuit 204 using an isolated interface 214, and the controller 208 may receive one or more or impedance data, current data, and voltage data via the isolated interface 214. The data and commands may be sent via the interface 214 using Isolated Control Area Network (ISO-CAN) protocol, Isolated Serial Port Interface (ISO-SPI) protocol, 10BaseT1S protocol, 10BaseT1L protocol, or other isolated interface protocol. In certain examples, the isolated interface 214 is a wireless interface. For instance, the controller 208 sends commands to the stimulus circuit 204 for synchronization of the timing of the AC stimulus and the beginning of measurements to determine impedance. The measurement data may be communicated at the sampled rate or a decimated rate via the isolated interface 214. The impedance measurement circuit 206 may include a synchronous or asynchronous sample rate converter that provides the measurement data at a rate that is an integer multiple of the frequency of the AC stimulus.

The magnitude of the AC stimulus is a fraction of the magnitude of the DC stimulus. For instance, the stimulus circuit 204 may provide the AC stimulus with power that is 5 hundredths (0.05x) the output power of the DC stimulus. As explained previously herein, the stimulus circuit 204 provides the AC stimulus at multiple frequencies (e.g., over a frequency range of 1Hz-10kHz).

The stimulus circuit 204 may produce the DC stimulus from AC line power using a rectifier. Typically, rectifier circuits are designed to suppress the line frequency (e.g., 50Hz or 60Hz) in the resulting DC voltage. In some examples, the stimulus circuit 204 includes a rectifier designed to emphasize the line frequency as an AC stimulus frequency instead of suppressing the line frequency. The stimulus circuit 204 may produce AC signals at the line frequency and multiples of the line frequency for the AC stimulus. The stimulus circuit 204 may include a switching converter to regulate DC output. The stimulus circuit may produce AC signals at the switching frequency and harmonic frequencies of the switching frequency. The AC signals may or may not be sinusoidal signals.

In some examples, the stimulus circuit 204 includes an analog-to-digital converter (ADC) to measure the frequencies of the AC signals and the frequency measurements are provided to the controller 208. This provides a more accurate measurement of impedance as a function of frequency in the EIS monitoring performed by the system. In certain examples, the electrochemical cell stack 102 may have a natural cell self-resonant frequency that may coincide with a harmonic of the line frequency. The impedance measurements can be made using an AC stimulus of the cell resonant frequency and harmonics of the cell resonant frequency.

The stimulus circuit 204 may include a single power supply circuit and the DC stimulus and the AC stimulus are both supplied by the same power supply circuit. In some examples, the stimulus circuit 204 includes two power supply circuits; a DC power supply circuit to supply the DC stimulus and a separate AC power supply circuit to supply the AC stimulus. In some examples, the two power supply circuits of the stimulus circuit 204 include a hybrid power supply circuit that can supply both AC and DC stimuli and another AC power supply circuit.

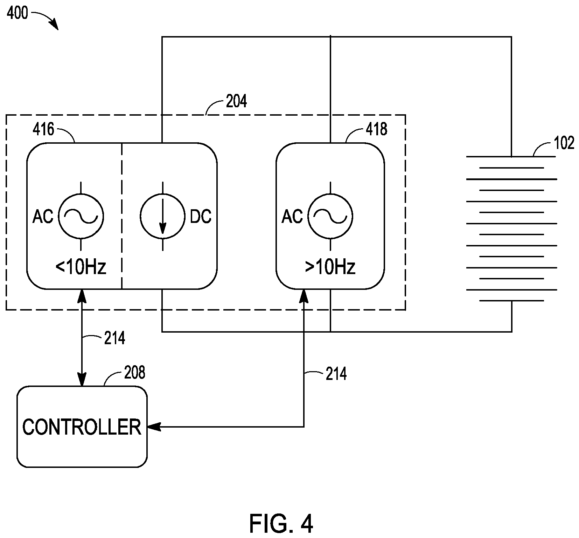

FIG. 4 is a block diagram of another example of portions of an electrochemical system 400. The stimulus circuit 204 includes a hybrid power supply circuit 416 and an AC power supply circuit 418. The impedance measurement circuit is not shown for simplicity of the diagram. The hybrid power supply circuit 416 provides the DC bias and lower frequency AC stimulus. For AC stimuli in the lower frequency range (e.g., <10Hz), the controller 208 configures the hybrid power supply circuit 416 to deliver the DC stimulus and deliver the AC stimulus at multiple frequencies up to 10Hz. The impedance circuit measures the electrochemical impedance using an AC stimulus provided by the hybrid power supply circuit 416 for the lower frequency range of impedance measurement. For higher frequencies (e.g., >10Hz), the controller 208 configures the hybrid power supply to deliver a constant DC current without an AC component and configures the AC power supply circuit 418 to deliver that AC stimulus at frequencies above 10Hz. The impedance circuit measures the electrochemical impedance using an AC stimulus from the AC power supply circuit 418 for the higher frequency range.

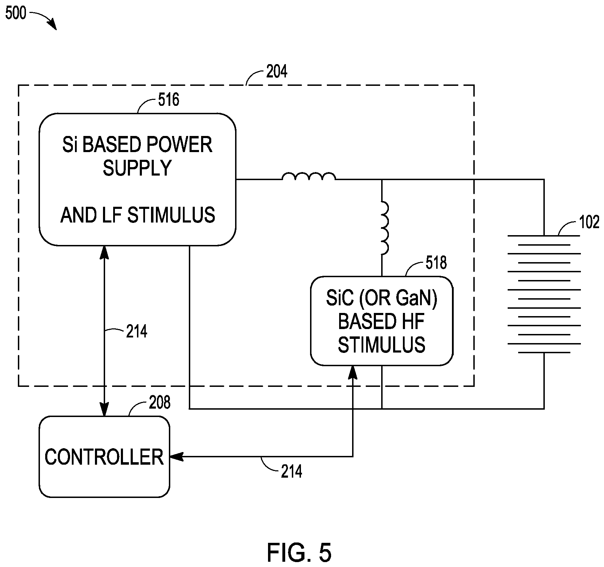

FIG. 5 is a block diagram of another example of portions of an electrochemical system 500. The stimulus circuit 204 includes a hybrid power supply circuit 516 and an AC power supply circuit 518. The hybrid power supply circuit 416 provides the DC bias and lower frequency (LF) AC stimulus, and the AC power supply circuit 58 provides the higher frequency (HF) AC stimulus. Both the hybrid power supply circuit 516 and the AC power supply circuit 518 are switching power supply circuits. The hybrid power supply circuit 516 and the AC power supply circuit 518 are partitioned based on power switch technology. For example, the hybrid power supply circuit 516 may include silicon (Si) based power switches and the AC power supply circuit 518 may include silicon carbide (SiC) power switches or gallium nitride (GaN) power switches to accommodate the higher signal frequencies. The controller 208 configures the hybrid power supply circuit 416 to deliver the DC stimulus and deliver the AC stimulus for impedance measurement in the lower frequency range, and configures the hybrid power supply circuit 516 to deliver the DC stimulus without an AC component and configures the AC power supply circuit 518 to deliver that AC stimulus for impedance measurement in the higher frequency range.

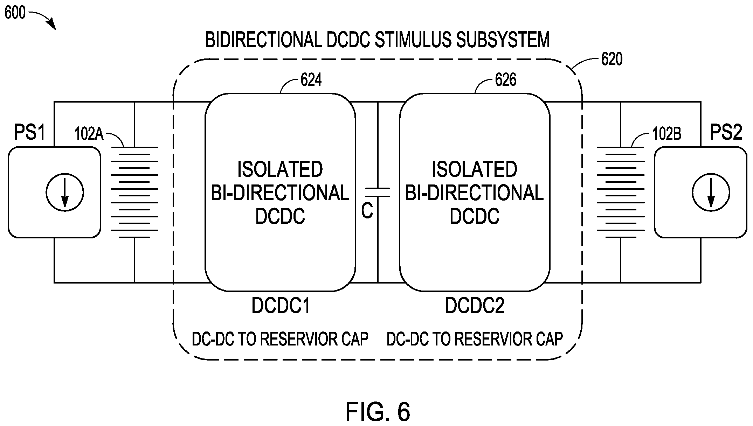

FIG. 6 is a block diagram of another example of portions of an electrochemical system 600. The system includes two electrochemical cell stacks 102 and two power supply circuits PS 1 and PS2. The power supply circuits provide the DC bias to the electrochemical cell stacks 102A, 102B. The AC stimulus is provided using a bidirectional DC-DC stimulus subsystem 620. The DC-to-DC stimulus subsystem 620 includes a first isolated bidirectional DC-to-DC converter 624 and a second isolated bidirectional DC-to-DC converter 626. The isolated bidirectional DC-to-DC converters may include a dual active bridge (DAB) topology that uses pulse width modulation (PWM) to produce the DC output power.

Each of the full-bridge DC-to-DC converters produce charge from the DC bias produced by its corresponding power supply circuit and stores the charge on an energy storage device. In the example of FIG. 6, the energy storage device is a reservoir capacitor (C), but other energy storage devices (e.g., a battery) could be used. The AC stimulus is supplied to the electrochemical cell stacks 102A, 102B using the charge stored on the reservoir capacitor. The DC-to-DC converters operate on opposite phases. For instance, in a first phase, the first isolated bidirectional DC-to-DC converter 624 is sinking current from the source PS1 to the reservoir capacitor and the second isolated bidirectional DC-to-DC converter 626 is sourcing current from the reservoir capacitor to electrochemical cell stack 102B. In a second phase, the first isolated bidirectional DC-to-DC converter 624 is sourcing current to electrochemical cell stack 102A from the reservoir capacitor and the second isolated bidirectional DC-to-DC converter 626 is sinking current from the source PS2 to the reservoir capacitor.

The energy stored in the reservoir capacitor determines the maximum AC stimulus current as well as the minimum frequency (fₘᵢₙ) of the AC stimulus. In some examples, the power supply circuits PS1 and PS2 are hybrid power supply circuits. Below the minimum frequency (fₘᵢₙ) of the bidirectional DC-DC stimulus subsystem 620, the power supply circuits provide the AC stimulus.

As explained previously herein, the example EIS capable electrochemical systems described herein can be used with hydrogen electrolyser systems. The DC bias produced by the stimulus circuits may be the DC operating energy used to produce hydrogen in the hydrogen producing cells. The EIS capable electrochemical systems can also be used with battery systems. The DC bias may be DC charging energy and the AC stimulus allows impedance measurements to be made during a charging cycle of the battery cells or the battery modules of the battery system.

The EIS data collected and processed by the electrochemical systems described herein can be used to predict the health of an electrochemical cell or an electrochemical cell stack, predict the degradation of the cells or cell stack, and identify problem cells to be replaced in an electrochemical cell system.

### ADDITIONAL DESCRIPTION AND ASPECTS

A first Aspect (Aspect 1) includes subject matter (such as a measurement device for an electrochemical system) comprising a stimulus circuit configured to simultaneously apply a direct current (DC) stimulus and an alternating current (AC) stimulus to one or more electrochemical cells of the electrochemical system, wherein the AC stimulus is applied at multiple frequencies, an impedance measurement circuit configured to measure impedance of the one or more electrochemical cells, and a controller configured to synchronize application of the DC stimulus and AC stimulus with measuring of impedance at the multiple frequencies and record the measured impedance of the one or more electrochemical cells.

In Aspect 2, the subject matter of Aspect 1 optionally includes impedance measurement circuit that includes a current sensor to measure an AC stimulus current applied to the one or more electrochemical cells at the multiple frequencies and a voltage sensor configured to measure a voltage of the one or more electrochemical cells when measuring the AC stimulus current. The controller is optionally configured to determine the electrochemical impedance at the multiple frequencies using the measurements of the AC stimulus current and the voltage of the one or more electrochemical cells.

In Aspect 3, the subject matter of one or both of Aspects 1 and 2 optionally includes a power supply circuit configured to deliver both the DC stimulus and the AC stimulus to the one or electrochemical cells.

In Aspect 4, the subject matter of one or both of Aspects 1 and 2 optionally includes a hybrid power supply circuit configured to deliver the DC stimulus and a first frequency range of the AC stimulus, and an AC power supply circuit configured to deliver a second frequency range of the AC stimulus.

In Aspect 5, the subject matter of one or both of Aspects 1 and 2 optionally includes a DC power supply circuit configured to apply the DC stimulus, and an AC power supply circuit configured to apply the AC stimulus.

In Aspect 6, the subject matter of one or any combination of Aspects 1-5 optionally includes a DC-to-DC converter circuit configured to produce charge from the DC stimulus, store the charge on a reservoir capacitor, and provide the AC stimulus using the reservoir capacitor.

In Aspect 7, the subject matter of Aspect 6 optionally includes electrochemical cells that include a first stack of at least one electrochemical cell and a second stack of at least one electrochemical cell, and a DC-DC converter circuit including a first bidirectional DC-to-DC converter circuit configured to supply the AC stimulus to the first electrochemical cell stack during a first operating phase and stores charge on the reservoir capacitor during a second operating phase, and a second bidirectional DC-to-DC converter circuit configured to store charge on the reservoir capacitor during the first operating phase and supply the AC stimulus to the second electrochemical cell stack during the second operating phase.

In Aspect 8, the subject matter of one or any combination of Aspects 1-7 optionally includes a power supply circuit configured to provide an AC stimulus that includes multiple frequencies derived from one or both of a line frequency and a switching frequency of a switching converter circuit.

Aspect 9 includes subject matter (such as a method of electrochemical system testing) or can optionally be combined with one or any combination of Aspects 1-8 to include such subject matter, comprising applying a direct current (DC) bias to one or more electrochemical cells of the electrochemical system, applying an alternating current (AC) stimulus of multiple frequencies with the DC bias to the one or more electrochemical cells, determining electrochemical impedance of the one or more electrochemical cells at the multiple frequencies, and producing an indication of condition of the one or more electrochemical cells using the determined electrochemical impedance at the multiple frequencies.

In Aspect 10, the subject matter of Aspect 9 optionally includes applying the AC stimulus to the one or more electrochemical cells, waiting a specified settling time, and measuring AC stimulus current and AC stimulus voltage at the multiple frequencies and determining the electrochemical impedance using measured AC stimulus current and AC stimulus voltage.

In Aspect 11, the subject matter of one or both of Aspects 9 and 10 optionally includes supplying both of the DC bias and the AC stimulus using a same power supply circuit.

In Aspect 12, the subject matter of one or both of Aspects 9 and 10 optionally includes supplying the DC bias and a first frequency range of the AC stimulus using a hybrid power supply circuit, and supplying a second frequency range of the AC stimulus using an AC power supply circuit.

In Aspect 13, the subject matter of one or both of Aspects 9 and 10 optionally includes supplying the DC bias using a DC power supply circuit, and supplying the AC stimulus using an AC power supply circuit.

In Aspect 14, the subject matter of one or any combination of Aspects 9-13 optionally includes using a DC-to-DC converter circuit to produce charge from the DC bias, storing the charge produced by the DC-to-DC converter circuit on an energy storage device, and supplying the AC stimulus using the energy storage device.

In Aspect 15, the subject matter of one or any combination of Aspects 9-14 optionally includes supplying, using a first bidirectional DC-to-DC converter circuit, the AC stimulus to a first electrochemical cell stack during a first phase and storing charge on the reservoir capacitor during a second phase, and supplying, using a second bidirectional DC-to-DC converter circuit, the AC stimulus to a second electrochemical cell stack during the second phase and storing charge on the reservoir capacitor during the first phase.

In Aspect 16, the subject matter of one or any combination of Aspects 9-15 optionally includes applying the AC stimulus having one or both of a line grid frequency and a stimulus switching frequency and having one or more other frequencies derived from the one or both of the line grid frequency and the stimulus switching frequency.

Aspect 17 includes subject matter (such as an electrochemical system) or can optionally be combined with the subject matter of one or any combination of Aspects 1-16 to include such subject matter, comprising at least one electrochemical cell stack, a measurement device and a controller. The at least one electrochemical cell stack includes multiple electrochemical cells. The measurement device includes a stimulus circuit configured to simultaneously apply a direct current (DC) stimulus and an alternating current (AC) stimulus to the at least one electrochemical cell stack, wherein the AC stimulus is applied at multiple frequencies, and an impedance measurement circuit configured to measure impedance of the electrochemical cells. The controller is configured to synchronize application of the DC stimulus and AC stimulus with measuring of the impedance at the multiple frequencies and record the measured impedance of the electrochemical cells.

In Aspect 18, the subject matter of Aspect 17 optionally includes an impedance measurement circuit including a current sensor to measure an AC stimulus current of the AC stimulus applied to the electrochemical cells at the multiple frequencies, a voltage sensor configured to measure an AC stimulus voltage of the electrochemical cells resulting from the AC stimulus current. The controller is optionally configured to sweep frequency of the AC stimulus current to multiple frequencies and determine the impedance at the multiple frequencies using the measurements of the AC stimulus current and the AC stimulus voltage.

In Aspect 19, the subject matter of one or both of Aspects 17 and 18 optionally includes at least one electrochemical cell stack including multiple hydrogen electrolyser cells connected in series, and the DC stimulus is used to operate the hydrogen electrolyser cells.

In Aspect 20, the subject matter of one or any combination of Aspects 17-19 optionally includes at least one electrochemical cell stack including multiple battery cells connected in series.

These non-limiting Aspects can be combined in any permutation or combination. The above detailed description includes references to the accompanying drawings, which form a part of the detailed description. The drawings show, by way of illustration, specific embodiments in which the invention can be practiced. These embodiments are also referred to herein as "examples." All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects. Method examples described herein can be machine or computer-implemented at least in part.

## Claims

1. A measurement device for an electrochemical system, the device comprising:
a stimulus circuit configured to simultaneously apply a direct current (DC) stimulus and an alternating current (AC) stimulus to one or more electrochemical cells of the electrochemical system, wherein the AC stimulus is applied at multiple frequencies;
an impedance measurement circuit configured to measure impedance of the one or more electrochemical cells; and
a controller configured to synchronize application of the DC stimulus and AC stimulus with measuring of impedance at the multiple frequencies and record the measured impedance of the one or more electrochemical cells.

2. The device of claim 1, wherein the impedance measurement circuit includes:
a current sensor to measure an AC stimulus current applied to the one or more electrochemical cells at the multiple frequencies; and
a voltage sensor configured to measure a voltage of the one or more electrochemical cells when measuring the AC stimulus current; and
wherein the controller is configured to:
determine the electrochemical impedance at the multiple frequencies using the measurements of the AC stimulus current and the voltage of the one or more electrochemical cells.

3. The device of claims 1 or 2, wherein the stimulus circuit includes either:
a) a power supply circuit configured to deliver both the DC stimulus and the AC stimulus to the one or electrochemical cells;
b) a DC power supply circuit configured to apply the DC stimulus, and an AC power supply circuit configured to apply the AC stimulus; and/or
c) a hybrid power supply circuit configured to deliver the DC stimulus and a first frequency range of the AC stimulus, and an AC power supply circuit configured to deliver a second frequency range of the AC stimulus.

4. The device of any of claims 1 to3, wherein the stimulus circuit includes:
a DC-to-DC converter circuit configured to:
produce charge from the DC stimulus;
store the charge on a reservoir capacitor; and
provide the AC stimulus using the reservoir capacitor.

5. The device of claim 4,
wherein the one or more electrochemical cells include a first stack of at least one electrochemical cell and a second stack of at least one electrochemical cell; and
wherein the DC-to-DC converter circuit includes:
a first bidirectional DC-to-DC converter circuit configured to supply the AC stimulus to the first electrochemical cell stack during a first operating phase and stores charge on the reservoir capacitor during a second operating phase; and
a second bidirectional DC-to-DC converter circuit configured to store charge on the reservoir capacitor during the first operating phase and supply the AC stimulus to the second electrochemical cell stack during the second operating phase.

6. The device of any of claims 1 to 5, wherein the stimulus circuit includes:
a power supply circuit configured to provide the AC stimulus; and
wherein the AC stimulus includes multiple frequencies derived from one or both of a line frequency and a switching frequency of a switching converter circuit.

7. A method of electrochemical system testing, the method comprising:
applying a direct current (DC) bias to one or more electrochemical cells of the electrochemical system;
applying an alternating current (AC) stimulus with the DC bias to the one or more electrochemical cells, wherein the AC stimulus is applied at multiple frequencies;
determining electrochemical impedance of the one or more electrochemical cells at the multiple frequencies; and
producing an indication of condition of the one or more electrochemical cells using the determined electrochemical impedance at the multiple frequencies.

8. The method of claim 7, wherein the determining the electrochemical impedance includes:
applying the AC stimulus to the one or more electrochemical cells;
waiting a specified settling time; and
measuring AC stimulus current and AC stimulus voltage at the multiple frequencies and determining the electrochemical impedance using measured AC stimulus current and AC stimulus voltage.

9. The method of any of claims 7 or 8, wherein the applying the DC bias and the applying the AC stimulus includes one or more of:
a) supplying both of the DC bias and the AC stimulus using a same power supply circuit;
b) supplying the DC bias and a first frequency range of the AC stimulus using a hybrid power supply circuit, and supplying a second frequency range of the AC stimulus using an AC power supply circuit; and/or
c) supplying the DC bias using a DC power supply circuit, and supplying the AC stimulus using an AC power supply circuit.

10. The method of claim any of claims 7 to 9, wherein the applying the AC stimulus includes:
using a DC-to-DC converter circuit to produce charge from the DC bias;
storing the charge produced by the DC-to-DC converter circuit on an energy storage device; and
supplying the AC stimulus using the energy storage device.

11. The method of any of claims 7 to 10, wherein the applying the AC stimulus includes:
supplying, using a first bidirectional DC-to-DC converter circuit, the AC stimulus to a first electrochemical cell stack during a first phase and storing charge on the reservoir capacitor during a second phase; and
supplying, using a second bidirectional DC-to-DC converter circuit, the AC stimulus to a second electrochemical cell stack during the second phase and storing charge on the reservoir capacitor during the first phase.

12. The method of any of claims 7 to 11, wherein the applying the AC stimulus includes applying the AC stimulus having one or both of a line grid frequency and a stimulus switching frequency, and having one or more other frequencies derived from the one or both of the line grid frequency and the stimulus switching frequency.

13. An electrochemical system, the system comprising:
at least one electrochemical cell stack including multiple electrochemical cells;
a measurement device including:
a stimulus circuit configured to simultaneously apply a direct current (DC) stimulus and an alternating current (AC) stimulus to the at least one electrochemical cell stack, wherein the AC stimulus is applied at multiple frequencies; and
an impedance measurement circuit configured to measure impedance of the electrochemical cells; and
a controller configured to synchronize application of the DC stimulus and AC stimulus with measuring of the impedance at the multiple frequencies and record the measured impedance of the electrochemical cells.

14. The system of claim 13, wherein the impedance measurement circuit includes:
a current sensor to measure an AC stimulus current of the AC stimulus applied to the electrochemical cells at the multiple frequencies;
a voltage sensor configured to measure an AC stimulus voltage of the electrochemical cells resulting from the AC stimulus current; and
wherein the controller is configured to sweep frequency of the AC stimulus current to multiple frequencies and determine the impedance at the multiple frequencies using the measurements of the AC stimulus current and the AC stimulus voltage.

15. The system of claims 13 or 14, wherein the at least one electrochemical cell stack includes:
a) multiple hydrogen electrolyser cells connected in series, and the DC stimulus is used to operate the hydrogen electrolyser cells; and/or
b) multiple battery cells connected in series.
